# EUROPEAN PATENT SPECIFICATION

(11) **EP 2 983 199 B1**
(45) Date of publication and mention of the grant of the patent: **03.03.2021**
(21) Application number: 13880950.4
(22) Date of filing: 24.10.2013
(51) Int. Cl.: H01L 21/683, H01L 21/687

(54) **CARRIER FOR SEMICONDUCTOR PROCESS**
TRÄGER FÜR HALBLEITERVERFAHREN
SUPPORT POUR PROCÉDÉ DE TRAITEMENT DE SEMI-CONDUCTEURS

(30) Priority: 02.04.2013 JP 2013076752
(43) Date of publication of application: 10.02.2016
(73) Proprietor: National Institute of Advanced Industrial Science and Technology, Tokyo 100-8921 (JP)
(72) Inventor: ITATANI, Taro, Tsukuba-shi Ibaraki 305-8568 (JP); ISHII, Hiroyuki, Tsukuba-shi Ibaraki 305-8568 (JP); AMANO, Yoshiyuki, Tsukuba-shi Ibaraki 305-8568 (JP); HAYASHI, Tsuneyuki, Tsukuba-shi Ibaraki 305-8568 (JP)
(74) Representative: Bennett, Nicholas
(86) International application number: PCT/JP2013/079477
(87) International publication number: WO 2014/162627

(56) References cited:
- WO-A2-2012/106191
- JP-A- 2000 009 665
- JP-A- 2003 142 563
- JP-A- 2003 142 563
- JP-A- 2006 024 697
- JP-A- 2006 518 930
- JP-A- 2010 073 884
- JP-U- H0 373 452
- US-A- 5 605 844
- US-B1- 6 228 685

## Description

### Technical field

The present invention relates to a semiconductor process carrier for enabling semiconductor manufacturing apparatuses for large-diameter silicon substrates to perform various processes for small-diameter or differently shaped semiconductor substrates (small substrates).

### Background art

In the field of manufacturing of semiconductor devices and circuits, development of production technologies, such as miniaturization, has focused mainly on silicon devices. The development of production technologies of silicon devices has been promoted by increasing the substrate size as well as by reducing the machining dimensions, and the technological development and reduction in manufacturing costs have been promoted simultaneously.

Until the year 2000, the market size of the industry of compound semiconductors other than silicon was 1% or less that of silicon devices. However, since 2010, it has exceeded 1% of the market size of the industry of silicon devices and is expected to further increase owing to the growth of the industry of LEDs using GaN-based materials, commercialization of power devices using SiC-based materials, and expansion of the market of RF devices, typically smart phones, using GaAs-based materials. Although the size of semiconductor substrates for compound semiconductor devices is expected to be increased to 6 inches or 8 inches in the future, it is generally 4 inches or less. Therefore, there is a demand for high production technologies for small-diameter substrates. In the field of micromachine systems and nanomachine systems, manufacturing apparatuses for old-generation small-diameter wafers having a size of 6 inches or less are commonly used. In addition, sensor technologies for differently shaped wafers or chips, such as rectangular semiconductor substrates, are required in a back-end process, such as three-dimensional packaging.

However, currently, every time the substrate size is changed, the transferring and processing systems of the apparatuses need to be replaced or modified. Furthermore, modification of a single semiconductor manufacturing apparatus is not sufficient, and the transferring and processing systems of the apparatuses for all of the manufacturing steps need to be modified. Therefore, high modification costs are incurred.

In light of the above-described circumstances, from the viewpoint of both economic efficiency and versatility, there has been a strong demand for means for processing a small-diameter semiconductor substrate or a differently shaped substrate without replacing or modifying the transferring and processing systems of the semiconductor manufacturing apparatuses.

A contrivance has been proposed in which a pocket-shaped recess is formed by spot-facing or the like in a substrate suitable for a transferring system of a processing apparatus, the recess receiving a small-diameter semiconductor substrate to adapt the small-diameter semiconductor substrate to the transferring system of the apparatus (for example, Japanese Unexamined Patent Application Publication No. 10-79418: Patent Reference 1). Other contrivances have also been proposed in which the small-diameter semiconductor substrate is bonded to an adapter substrate with any of various types of temporary fixing agents or adhesives, or is simply attached to the adapter substrate with wax or the like.

The invention proposed in Patent Reference 1 relates to transferring a substrate or a photomask for exposure, and is applied to a situation where the substrate is transferred while being "placed" on a transfer adapter. In addition, to achieve high positional accuracy, "a restraining member for restraining the periphery of the substrate is provided" is a requirement. Therefore, it is difficult to apply this invention to a common semiconductor manufacturing apparatus. This is because, in a common semiconductor manufacturing apparatus, the semiconductor substrate is transferred, processed, or machined using vacuum chuck or an electrostatic chuck. With the means for "retaining the periphery", there is a risk that the semiconductor substrate will fall when the substrate is vertically held or inverted. In addition, there may be a case where resistance to high temperatures is required.

Examples of patents related to semiconductor manufacturing and transferring processes using a polyimide film include Japanese Unexamined Patent Application Publication No. 5-114618 (Patent Reference 2) which relates to a device sealing method in which a polyimide film is used; Japanese Unexamined Patent Application Publication No. 9-162247 (Patent Reference 3) which relates to a mounting method in which polyimide tape is used; Japanese Unexamined Patent Application Publication No. 2002-134567 (Patent Reference 4) which relates to a polyimide-based film used in a mounting process; Japanese Unexamined Patent Application Publication No. 2003-34736 (Patent Reference 5) which relates to TAB tape including a polyimide film; Japanese Unexamined Patent Application Publication No. 2004-7160 (Patent Reference 6) which relates to a method for mounting a chip on polyimide tape; and Japanese Unexamined Patent Application Publication No. 2006-518930 (Patent Reference 7) which relates to a method for placing a composite substrate including a polyimide film and a conductive film in an apparatus and retaining the composite substrate with an electrostatic chuck. There are no patents related to transferring, processing, or machining generally performed by semiconductor manufacturing apparatuses, for which the present invention is to provide a solution to a problem, 11

Further patent documents related to semiconductor manufacturing and transferring processes are JP2003142563 A and JP2006518930 A. 11

The first document discloses a semiconductor process carrier including a transferring base portion formed of a semiconductor substrate for enabling a small substrate to be held, wherein an opening is formed in the transferring base portion, and a film is attached to a bottom surface of the transferring base portion so as to cover the opening, wherein holes for securing the small substrate by vacuum chuck are formed in the film. JP2006518930 A discloses instead a semiconductor process carrier for use on an electrostatic chuck, wherein the semiconductor process carrier includes a transferring base portion formed of a metallic material for enabling a small substrate to be held, wherein an opening is formed in the transferring base portion, and a polyimide film is attached to a bottom surface of the transferring base portion so as to cover the opening, wherein a small substrate is accommodated in the opening, the small substrate having a diameter smaller than a diameter of the transferring base portion.

### Citation list

### Patent references

Patent Reference 1: Japanese Unexamined Patent Application Publication No. 10-79418
Patent Reference 2: Japanese Unexamined Patent Application Publication No. 5-114618
Patent Reference 3: Japanese Unexamined Patent Application Publication No. 9-162247
Patent Reference 4: Japanese Unexamined Patent Application Publication No. 2002-134567
Patent Reference 5: Japanese Unexamined Patent Application Publication No. 2003-34736
Patent Reference 6: Japanese Unexamined Patent Application Publication No. 2004-7160
Patent Reference 7: Japanese Unexamined Patent Application Publication No. 2006-518930

### Summary of the Invention

### Problems to be solved by the Invention

In light of the above-described circumstances, an object of the present invention is to provide a semiconductor process carrier that can be used in a common semiconductor manufacturing process, the semiconductor process carrier enabling semiconductor manufacturing apparatuses for large-diameter silicon substrates, without modification thereof, to perform processes of transferring and machining small-diameter or differently shaped semiconductor substrates (small substrates), or realizing high-temperature processes for SiC, GaN, etc., which have recently been attracting attention and anticipated to be good semiconductor materials.

### Means for solving the problems

To achieve the above-described object, according to an aspect of the present invention, there is provided a combination of a semiconductor process carrier for use on an electrostatic chuck and an electrostatic chuck stage, wherein the semiconductor process carrier includes a transferring base portion formed of a semiconductor substrate for enabling a small substrate to be held,
wherein an opening is formed in the transferring base portion, and a polyimide film is attached to a bottom surface of the transferring base portion so as to cover the opening,
wherein a small substrate is accommodated in the opening, the small substrate having a diameter smaller than a diameter of the transferring base portion or a shape different from a shape of the transferring base portion,
wherein a hole for securing the small substrate by vacuum chuck or cooling the small substrate is formed in the polyimide film covering the opening and
wherein the transferring base portion and the small substrate are attached by an electrostatic force to an electrostatic chuck stage, and
wherein the polyimide film is disposed between the transferring base portion and the electrostatic chuck stage.

In the semiconductor process carrier, the semiconductor process carrier may be retainable, together with the small substrate that is held, at a predetermined position in a semiconductor manufacturing apparatus by an electrostatic chuck when a high voltage of 1 kV or more is applied through the polyimide film.

The opening may be formed by an air-spindle grinding method or an ultrasonic machining method.

The polyimide film may have a thickness of 50 µm or less.

The semiconductor process carrier may include a structure including a substrate-receiving portion and a substrate-accommodating portion and disposed at a side of the opening opposite to a side at which the polyimide film is attached, the structure receiving and accommodating the small substrate in an attachable and detachable manner, and preventing the small substrate from falling while being transferred or rotated in the semiconductor manufacturing apparatus.

In an example that may be useful for understanding the invention, a semiconductor process carrier is formed by subjecting a transferring base portion formed of a semiconductor substrate to a process for enabling a small substrate to be chucked, the small substrate having a diameter smaller than a diameter of the transferring base portion or a shape different from a shape of the transferring base portion. The semiconductor process carrier includes a structure including a substrate-receiving portion and a substrate-accommodating portion and formed as a result of the process for enabling the small substrate to be held, the structure receiving and accommodating the small substrate in an attachable and detachable manner, and preventing the small substrate from falling while being transferred or rotated in the semiconductor manufacturing apparatus.

This structure including the substrate-receiving portion and the substrate-accommodating portion may be formed by an air-spindle grinding method or an ultrasonic machining method.

This structure including the substrate-receiving portion and the substrate-accommodating portion may have an attaching-detaching structure that partially covers a space defined by the structure and enables the small substrate to be attached and detached obliquely from above.

The structure including the substrate-receiving portion and the substrate-accommodating portion and the transferring base portion may be bonded together by surface activation bonding achieved by exposure to plasma.

The structure including the substrate-receiving portion and the substrate-accommodating portion may be made of silicon. Alternatively, the transferring base portion and the structure including the substrate-receiving portion and the substrate-accommodating portion may be made of a compound semiconductor material other than silicon.

A hole for securing the small substrate by vacuum chuck or cooling the small substrate is formed in the semiconductor process carrier. The process for enabling the small substrate to be held may be achieved by a semiconductor process.

### Effects of the Invention

By using the structure according to the present invention, transferring and machining processes for a small substrate can be performed by using a semiconductor manufacturing apparatus for large-diameter silicon substrates or high-temperature semiconductor processes without modification. Thus, special modification for the semiconductor manufacturing apparatus is not necessary. In addition, in the processes of transferring and machining systems, by retaining the transferring base portion with an electrostatic chuck, the small substrate is fixed by an attraction force. Therefore, the small substrate can be prevented from falling or being displaced while being transferred, and can also be subjected to high-temperature processes. Owing to these advantages, semiconductor manufacturing apparatuses for large-diameter silicon substrates and semiconductor manufacturing apparatuses for high-temperature processes may be easily applied to processes for small substrates without modification. Thus, the production cost can be reduced and the production efficiency can be increased.

The semiconductor process carrier according to the present invention may include a silicon substrate whose base is a large-diameter silicon wafer with a diameter of, for example, 6 or 8 inches that has been commonly used in semiconductor manufacturing apparatuses. In such a case, unlike the case in which a material other than silicon or semiconductors, such as a ceramic material, a metal material, or a common glass material, is used, physical constants such as the elastic modulus, specific gravity, and coefficient of thermal expansion are very close to those of silicon. Therefore, troubles do not easily occur in the transferring and machining systems. In addition, since the reflection conditions of a silicon surface can be directly used, a mark that serves as a positioning reference on the semiconductor process carrier can be easily detected. Furthermore, since no impurities are contained, problems of contamination do not occur. When a hole for vacuum chucking is provided, Z pin embodiments not forming part of the present invention the small substrate can be fixed to a transferring arm while being transferred, and to a stage while being processed or machined. Therefore, separation or falling of the small substrate can be prevented, and reduction in accuracy during exposure, for example, can also be prevented. When the mark that serves as a positioning reference is positioned with respect to a notch or an orientation flat of a base substrate with high accuracy (X, Y < ±200 µm, Θ < 1 degrees), a batch process can be achieved by self-alignment. Thus, the throughput of the process can be greatly improved.

In the configuration of the present invention, in which the polyimide film is attached to the transferring base portion, since the polyimide film can be substantially regarded as an insulator, the small substrate is fixed directly by an electrostatic force of an electrostatic chuck. When a voltage of 1.0 kV is applied, the attraction force, which depends on the distance between silicon and the electrostatic chuck, is experimentally determined as follows. That is, the attraction force is 90 [gf/cm²] for 50 µm, 12.6 [gf/cm²] for 100 µm, 4.4 [gf/cm²] for 200 µm, and 2.7 [gf/cm²] for 300 µm. In an apparatus required to have a He cooling function, such as an etching apparatus, it has been experimentally determined that the attraction force needs to be 15 [gf/cm²] or more. Therefore, in the case where a stable fixing force is required, it is effective to set the thickness of the polyimide film to 50 µm or less.

In embodiments not forming part of the present invention, the *structure* including the substrate-receiving portion and the substrate-accommodating portion may be bonded to the transferring base portion, which serves as a base, by surface activation bonding achieved by exposure to plasma. Thus, a mechanism for fixing or detachably attaching the small substrate can be provided. When this structure is provided, an ion implantation apparatus in which a semiconductor substrate is placed concentrically on a disc-shaped rotating member and is implanted with ions while being rotated or an ion implantation apparatus which implants ions into a wafer while moving the wafer vertically may also be used without modification. The semiconductor substrate receives a centrifugal force during the rotation (in the case of less than 300 mm, r = 50 cm and 1200 rpm; in the case of 300 mm, r = 750 mm and 750 rpm), and therefore a fixing method that provides sufficient resistance to this force is required. Also, a manufacturing process of a power transistor using SiC includes an ion implantation step performed at a temperature as high as, for example, 600°C. Therefore, a heat-resistant carrier having a fixing method that provides resistance to the centrifugal force is effective.

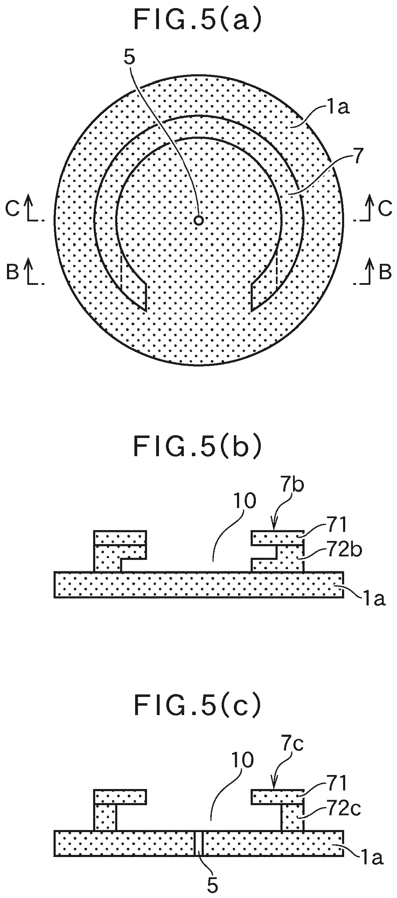

When a carrier subjected to grinding for spot-facing is used in a high-temperature process, there is a risk that the silicon carrier will crack due to a residual strain. A silicon carrier in which polyimide is used is only resistant to heat up to about 500°C. Accordingly, a semiconductor process carrier according to embodiments not forming part of the present invention was manufactured by bonding a structure, formed in a C-shape by a hollowing process, to a silicon substrate by the above-described technology (see Fig. 5). It was confirmed that, even when a heating cycle test (temperature was increased to 1000°C and maintained for an hour) was repeated 11 times, the area and distribution of the bonding portion in an infrared image (white area) did not vary. In addition, the number of interference fringes formed by visible light on the carrier portion did not change from about 20 (projections and recesses were about 6 µm). Therefore, it was confirmed that no warping or cracking occurred due to the cycle test in which the temperature was increased to 1000°C. Based on the above-described results, it was confirmed that the silicon carrier subjected to the experiment as an example of a semiconductor process carrier according to embodiments not forming part of the present invention was sufficiently resistant to an annealing process.

### Brief Description of the Drawings

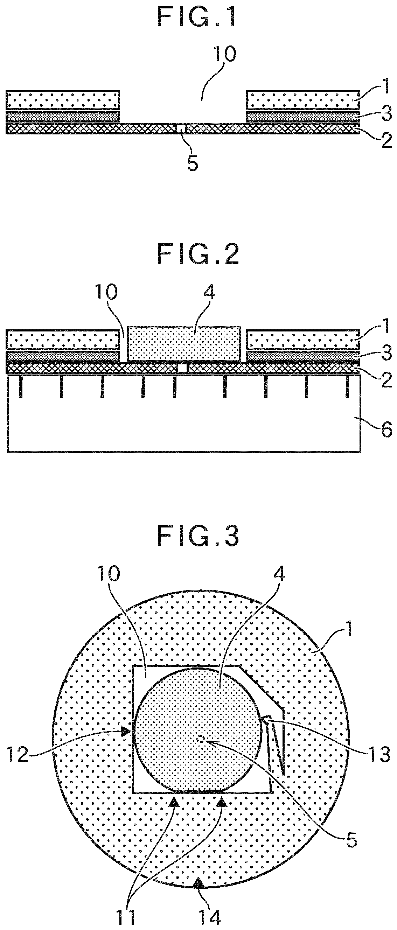

Fig. 1 is a sectional view illustrating a semiconductor process carrier, which may be useful for understanding the invention
Fig. 2 is a sectional view of a first embodiment of the present invention illustrating the state in which a sample is placed on the semiconductor process carrier according to figure 1.
Fig. 3 is a plan view of the semiconductor process carrier used in the first embodiment of the present invention.

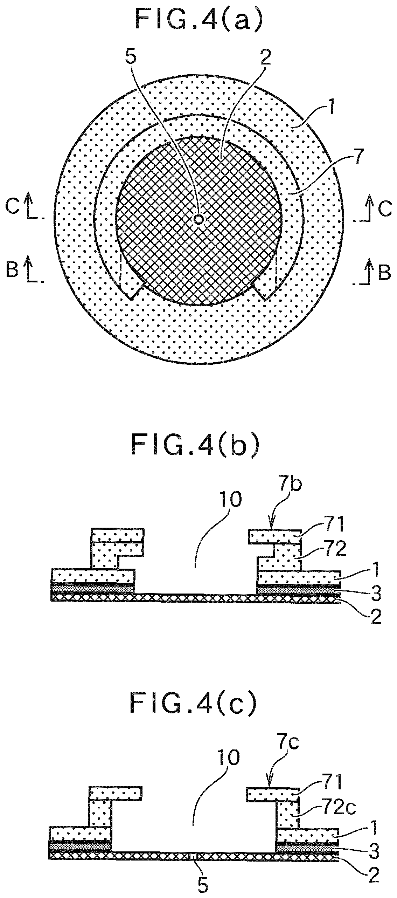

Fig. 4 shows diagrams of a semiconductor process carrier which may be useful for understanding the invention, illustrating a structure which prevents a small substrate from falling while being, for example, transferred or rotated in a manufacturing apparatus and which enables the small substrate to be attached and detached, where (a) is a plan view, (b) is a sectional view illustrating a substrate-receiving portion taken at position B, and (c) is a sectional view illustrating a substrate-accommodating portion taken at position C.
Fig. 5 shows diagrams of a semiconductor process carrier which may be useful for understanding the invention, illustrating a structure which prevents a small substrate from falling while being, for example, transferred or rotated in a manufacturing apparatus, which enables the small substrate to be attached and detached, and which can be used in a high-temperature environment, where (a) is a plan view, (b) is a sectional view illustrating a substrate-receiving portion taken at position B, and (c) is a sectional view illustrating a substrate-accommodating portion taken at position C.

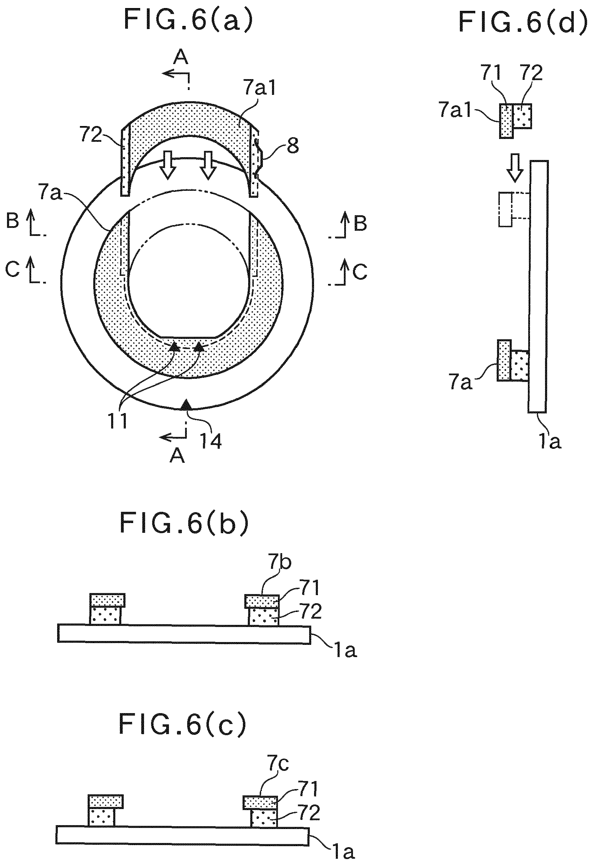

Fig. 6 shows diagrams of a semiconductor process carrier which may be useful for understanding the invention, illustrating a structure which prevents a small substrate from falling while being, for example, transferring or rotated in a manufacturing apparatus, which enables the small substrate to be attached and detached, and which can be used in a high-temperature environment, where (a) is a plan view, (b) is a sectional view illustrating a substrate-receiving portion taken at position B, (c) is a sectional view illustrating a substrate-accommodating portion taken at position C, and (d) is a vertical sectional view taken at position A, illustrating a movement of an opening/closing piece.

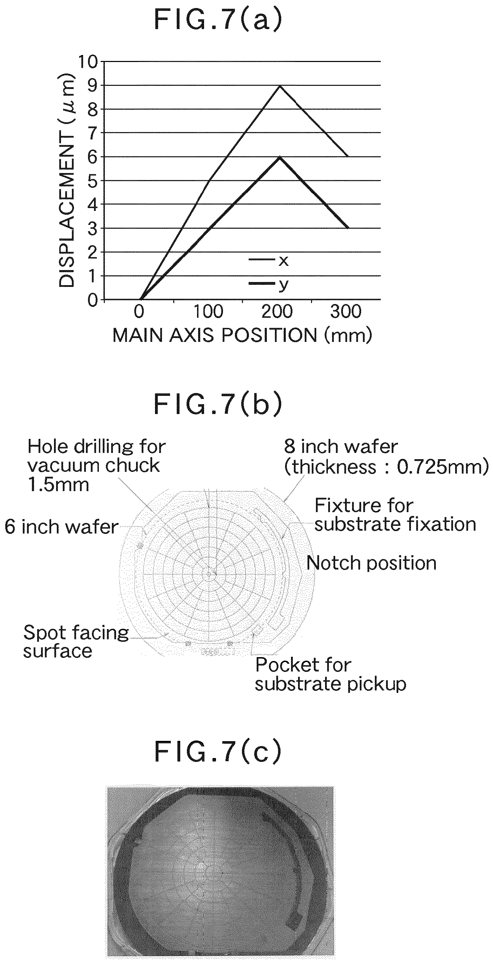

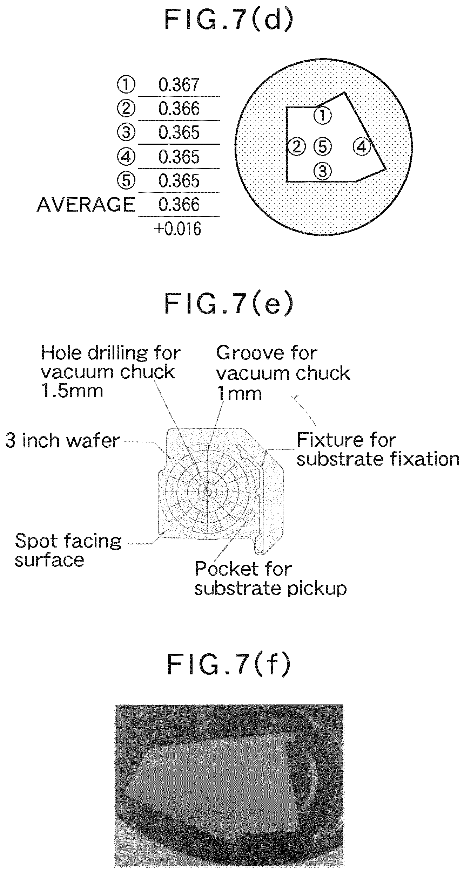

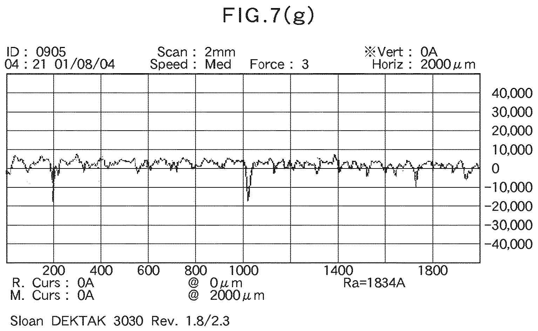

Fig. 7 shows the results of experiments related to machining of an opening or a space formed in a structure of a semiconductor process carrier which may be useful for understanding the invention, where (a) shows the polishing stage accuracy in terms of stage parallelism of a polishing device, (b) is a photograph of a design as a substitute for a diagram, (c) is a photograph of a trial product, (d) shows the measurement result of parallelism, (e) is a photograph of a design as a substitute for a diagram, (f) is a photograph of a trial product, and (g) illustrates the result of spot-facing performed to reduce the surface roughness in silicon grinding based on precision polishing, where the processing shape is that of spot-facing and the roughness is 0.183 µm.

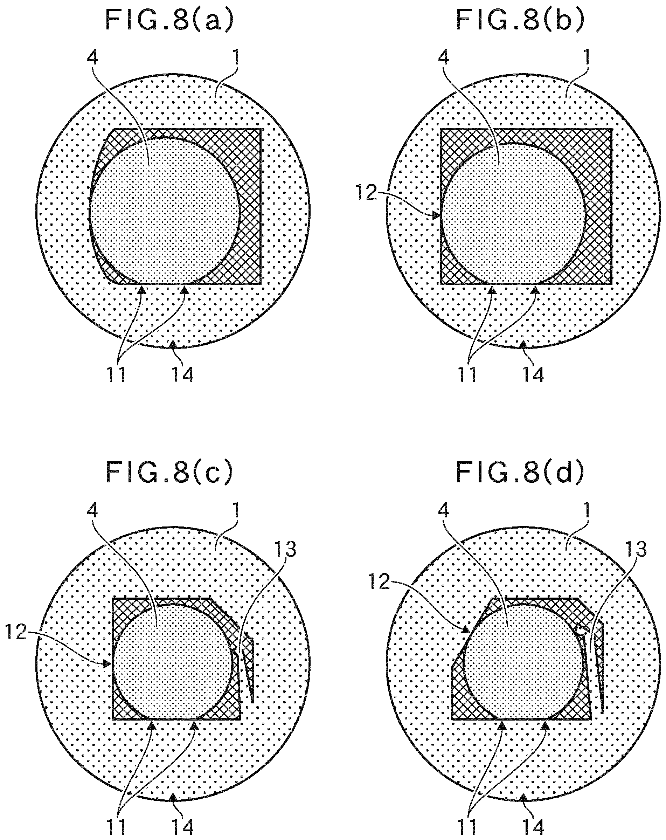

Fig. 8 shows examples of openings or spaces in structure of semiconductor process carriers according to the present invention, where (a) illustrates one-side contact, (b) illustrates two-side contact, and (c) and (d) illustrate three-side contact.

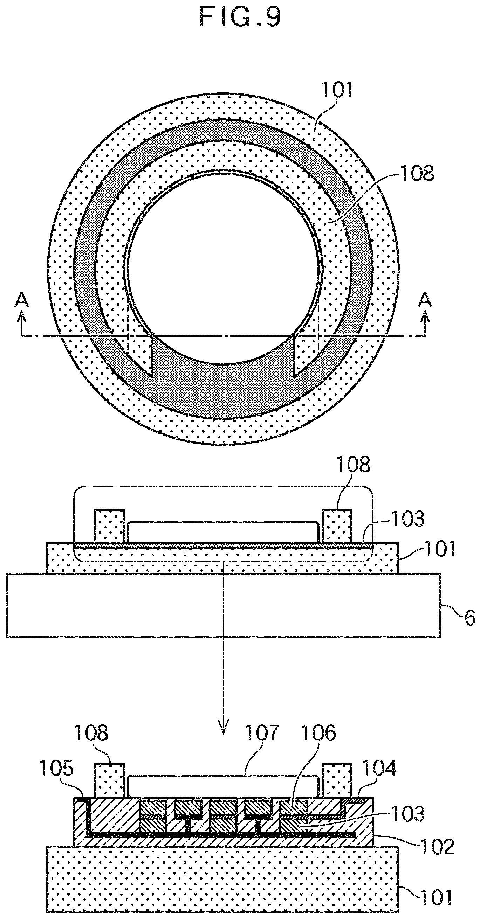

Fig. 9 illustrates a semiconductor process carrier which may be useful for understanding the invention, wherein a mechanism for holding a small substrate includes an insulator, electrodes, an insulator, a charge-storage layer, and an insulator that are formed by semiconductor processes and stacked in that order, and wherein the small substrate is retained by a bipolar electrostatic chuck when a voltage is externally applied to external terminals (V+, V-) included in a wiring layer, and is continuously retained by the charge stored in the charge-storage layer even after the external voltage is turned off.

### Modes for carrying out the Invention

An embodiment of the present invention and arrangements useful for understanding the invention will now be described with reference to the drawings. The embodiment described below is merely an example of the present invention, and various design changes are possible within the scope of the present invention as defined by the appended claims.

### First Embodiment

According to the present invention, a polyimide film 2 and a transferring base portion 1 are provided. The polyimide film 2 has favorable characteristics for use in a semiconductor process from the viewpoint of chemical resistance in a cleaning process, heat resistance, wear resistance, and low out-gas emissions. The transferring base portion 1 is obtained by processing a large-diameter silicon substrates with a diameter of, for example, 6 or 8 inches used in semiconductor manufacturing apparatuses for large-diameter silicon substrates. Since a large-diameter silicon substrate is used as the transferring base portion 1, even when a sapphire substrate 4, which will be described below as an example of a small substrate, is provided thereon, the transferring base portion 1 is recognized as a large-diameter silicon substrate by a transfer system, a processing system, and a machining system of a semiconductor manufacturing apparatus. The small substrate is fixed by an electrostatic chuck together with the transferring base portion 1, so that the small substrate can be subjected to transfer, processing, and machining without being dropped.

As illustrated in Fig. 1, a semiconductor process carrier used in an embodiment the present invention includes a polyimide film 2, which is an insulator having a thickness of 50 µm or less, and the transferring base portion 1 placed on the polyimide film 2. The transferring base portion 1 is formed of a silicon substrate, which is a frame having an opening 10 having a predetermined shape that accommodates a small substrate (for example, a sapphire substrate 4, which will be described below). The polyimide film 2 and the transferring base portion 1 are bonded together by being heated to 300°C to 400°C. As an adhesive, an adhesive portion 3 is used, which has thermosetting, fusion bonding, or thermoplastic characteristics, and is made of, for example, a heat-resistant adhesive such as an epoxy material or solvent-soluble polyimide material. The polyimide film 2 has a hole 5 used to fix the small substrate at a predetermined location in the semiconductor manufacturing apparatus by vacuum suction or cooling the small substrate in the semiconductor manufacturing apparatus.

From the viewpoint of versatility, for example, the transferring base portion 1 is preferably a standardized silicon wafer having a diameter of 6 to 12 inches. The small substrate is a substrate having a diameter smaller than that of the transferring base portion 1 or a shape different from the wafer shape of the transferring base portion 1 (for example, a rectangular shape). In addition to the sapphire substrate 4 described as an example in the present embodiment, the small substrate may be a GaN substrate, a SiC substrate, or a GaAs substrate.

As illustrated in Figs. 2 and 3, the sapphire substrate 4, which is an example of the small substrate, is accommodated in the opening 10 having the predetermined shape formed in the transferring base portion 1. As illustrated in Fig. 3, in particular, the opening 10 formed in the transferring base portion 1 has a first support 11 for supporting an orientation flat surface of the sapphire substrate 4 that extends along a crystal orientation thereof, and a second support 12 for supporting the sapphire substrate 4 at a position perpendicular to the first support 11. From the viewpoint of reliability of an alignment mechanism, a third support 13 is preferably provided to supports the sapphire substrate 4 at a point in a direction 180 degrees opposite to the direction in which the sapphire substrate 4 is supported by the second support 12. As illustrated in Fig. 3, from the viewpoint of uniformity of surface treatment, a reference point 14 that serves as a reference for the position at which the transferring base portion 1 is attached to the stage is preferably formed on the transferring base portion 1 at a position of the orientation flat or a notch.

As illustrated in Fig. 2, in the present invention, the sapphire substrate 4 is accommodated in the opening 10 formed in the transferring base portion 1. Even when the sapphire substrate 4 is accommodated, since the transferring base portion 1 is made of a silicon substrate, the transferring base portion 1 is attached by an electrostatic chuck to an electrostatic chuck stage 6, which serves as an electric-field generator in the semiconductor manufacturing apparatus, when an electric field is applied.

The electric field applied to activate the electrostatic chuck may be, for example, 1 kV. In the present invention, even when the electric field is turned off, the transferring base portion 1 is continuously attached to the electrostatic chuck stage 6 due to the residual electrostatic force. In addition, after a predetermined process has been performed in the semiconductor manufacturing apparatus, a reverse electric field is applied to cancel the residual electrostatic force, so that the transferring base portion 1 can be separated from the electrostatic chuck stage 6.

Here, polyimide is generally aromatic polyimide in which aromatic compounds are directly linked through imide bonds. Since the aromatic compounds are linked through the imide bonds to form a conjugated structure, polyimide has a rigid and strong molecular structure. In addition, since the imide bonds have strong intermolecular force, polyimide has the highest level of thermal, mechanical, and chemical characteristics among macromolecules, and is therefore suitable for use as a component of the present invention. For example, a Kapton-based polyimide film (Kapton is a registered trademark) produced by Du Pont is obtained by condensation polymerization of aromatic tetrabasic acid and aromatic diamine, and is suitable for use as a component of the present invention because of the following characteristics:
1) The mechanical characteristics in a high-temperature range are hardly different from those at a normal temperature.
2) The material has no melting point, is not carbonized unless the temperature is 500°C or higher, and does not have flame-spreading property.
3) The material is insoluble in almost all organic solvents, and has high chemical resistance even at high temperatures.
4) The material has good electrical characteristics, such as a high dielectric breakdown voltage and a small dielectric loss, over a wide temperature range.

A Upilex-based polyimide film (Upilex is a registered trademark) produced by Ube Industries, Ltd. is made from aromatic tetrabasic acid dianhydride, unlike the Kapton-based material, but has good mechanical characteristics, electrical insulation properties, chemical resistance, and heat resistance similar to the Kapton-based material. Also, when U-varnish, which is made from similar materials, is applied to a base member and baked at a high temperature, solvent is removed and imidization progresses, so that a polyimide coating having characteristics similar to those of a film is obtained. Thus, a thin polyimide coating film can be easily formed. Accordingly, the films and varnish are both suitable for use as a component of the present invention.

Alternatively, in embodiments not forming part of the present invention, plastics having high heat resistances, which are called super engineering plastics, may also be used as a component of the present invention. Examples of such a plastic include polyphenylene sulfide (PPS), polyarylate (PAR), polysulfone (PSF), polyether sulfone (PES), polyetherimide (PEI), polyamide imide (PAI), polyether ether ketone (PEEK), and liquid crystal polyester (LCP). In general, a heat-resistant plastic having a short-term heat resistance of 200°C or more and a long-term heat resistance of 150°C or more may be used.

The opening 10 in the transferring base portion 1 may be formed by an air spindle method, an ultrasonic method, or various other methods. For example, in machining and processing performed by the semiconductor manufacturing apparatus, high flatness and dimensional accuracy may be required. The air spindle method is an effective method for satisfying such a requirement. As illustrated in Fig. 7, with this method, the dimensional accuracy in the height direction is 10 µm or less, and the surface roughness is 0.2 µm or less. Although the accuracy will be reduced, the ultrasonic machining method is also an effective method depending on the use.

In the manufacturing process of micromachine systems (MEMS), an etching method called the Bosch method is used. With this method, a high aspect ratio can be achieved in a cross section perpendicular to the substrate. Although this method provides a high etching rate, the dimensional accuracy in the depth direction is dependent on the shape. In general, an etching depth of 500 µm varies about 30 µm depending on the shape. Therefore, by using the above-described air spindle method or ultrasonic machining method in addition to the etching method, the throughput and dimensional accuracy can both be increased.

Fig. 8 illustrates examples of openings 10 formed by the air spindle method which may be useful for understanding the invention, the examples including a configuration in which satisfactory positional accuracy is ensured by one-side contact, a configuration in which satisfactory positional accuracy is ensured by two-side contact, and examples of complex shapes.

### First arrangement

According to an alternative arrangement which may be useful for understanding the present invention, as illustrated in Fig. 4, a semiconductor process carrier may include, in addition to the configuration according to the first embodiment, a structure 7 including a substrate-receiving portion 7b and a substrate-accommodating portion 7c and disposed at a side of the opening 10 opposite to the side at which the polyimide film 2 is attached. The structure 7 receives and accommodates a small substrate (not shown) in an attachable and detachable manner, and prevents the small substrate from falling while being transferred or rotated in a semiconductor manufacturing apparatus.

The structure 7 including the substrate-receiving portion 7b and the substrate-accommodating portion 7c is formed by, for example, combining two members, which are a cover portion 71 and a spacer portion 72 formed in predetermined shapes by processing a material made of silicon, and is substantially C-shaped in plan view, as illustrated in Fig. 4(a). More specifically, the configuration that is substantially C-shaped in plan view including the substrate-receiving portion 7b, which serves as an inlet through which the small substrate is attached and detached, and the substrate-accommodating portion 7c, which accommodates the small substrate in the structure 7, may be formed by the air spindle grinding method or the ultrasonic machining method used to form the transferring base portion 1 in the first embodiment. Furthermore, from the viewpoint of reliability of the process, the substrate-receiving portion 7b preferably has an attaching-detaching structure (see, for example, Fig. 4(b)) in which the space defined by the structure 7 is partially covered with the cover portion 71 and the spacer portion 72 is processed so as to enable the small substrate to be attached and detached obliquely from above. The structure 7 may instead be formed of a compound semiconductor material other than silicon, such as sapphire, GaN, SiC, or GaAs.

A piece of object, for example, may be bonded to the transferring base portion 1 by surface activation bonding achieved by exposing the silicon surface to plasma. Specifically, the structure 7 and the transferring base portion 1 may be exposed to plasma for surface activation treatment, and then be pressurized and heated so that the structure 7 and the transferring base portion 1 come into tight contact with each other and are bonded together.

Similar to the opening 10 in the transferring base portion 1 according to the first embodiment, preferably, the structure 7 has a first support for supporting an orientation flat surface of the small substrate, the orientation flat surface extending along a crystal orientation thereof, and a second support for supporting the small substrate at a position perpendicular to the first support. In addition, more preferably, from the viewpoint of reliability of an alignment mechanism, a third support is provided to support the small substrate at a point in a direction 180 degrees opposite to the direction in which the small substrate is supported by the second support. From the viewpoint of uniformity of surface treatment, a mark that serves as a reference for the position at which the structure 7 is retained on the stage on which the process is performed in the apparatus is preferably formed on the structure 7.

### Second arrangement

According to another arrangement that may be useful for understanding the present invention, as illustrated in Fig. 5, a semiconductor process carrier includes a transferring base portion 1a formed of a large-diameter silicon substrate, and a structure 7 that is substantially C-shaped in plan view, the structure 7 including a substrate-receiving portion 7b and a substrate-accommodating portion 7c and being disposed on the transferring base portion 1a. The structure 7 receives and accommodates a small substrate (not shown) in an attachable and detachable manner, and prevents the small substrate from falling while being transferred or rotated in a semiconductor manufacturing apparatus.

The configuration of the second arrangement differs from those of the semiconductor process carriers according to the first embodiment and the first arrangement in that the polyimide film 2 is omitted and the opening 10 is not formed in the transferring base portion 1a. In the semiconductor process carrier according to the second arrangement, since the polyimide film 2 is omitted, a hole 5 is formed in the transferring base portion 1a, the hole 5 being used to fix the small substrate at a predetermined position in the semiconductor manufacturing apparatus by vacuum suction or cooling the small substrate in the semiconductor manufacturing apparatus. The methods for forming the configuration of the structure 7 including the substrate-receiving portion 7b and the substrate-accommodating portion 7c and bonding the structure 7 to the transferring base portion 1 are similar to those of the first arrangement, the structure 7 receiving and accommodating the small substrate in an attachable and detachable manner and preventing the small substrate from falling while being transferred or rotated in the semiconductor manufacturing apparatus. Similar to the first arrangement, first to third supports are preferably provided on the structure 7 so that the accommodated small substrate can be accurately positioned. Also in the present arrangement, the structure 7 may be formed of silicon or a compound semiconductor material other than silicon, such as sapphire, GaN, SiC, or GaAs.

### Third Arrangement

According to another arrangement which is useful for understanding the present invention, as illustrated in Fig. 6, a semiconductor process carrier may include a ring-shaped structure 7a in place of the structure 7 according to the second arrangement that is substantially C-shaped in plan view. The structure 7a includes an elastic member, such as a metal spring 8, and can be opened and closed. Thus, even when a special process in which, for example, the semiconductor process carrier may be transferred or rotated in any direction is performed in the semiconductor manufacturing apparatus, the ring-shaped structure 7a, which can be opened and closed, prevents a small substrate carried by the semiconductor process carrier from falling.

The methods for forming the configuration of the structure 7a, which includes a substrate-receiving portion and a substrate-accommodating portion, and an opening/closing piece 7a1, and bonding the structure 7a and the opening/closing piece 7a1 to the transferring base portion 1 are similar to those of the first arrangement, the structure 7a receiving and accommodating the small substrate in an attachable and detachable manner and preventing the small substrate from falling while being transferred or rotated in the semiconductor manufacturing apparatus. Similar to the first arrangement and the second arrangement, first to third supports are preferably provided on the structure 7 so that the accommodated small substrate can be accurately positioned. Also in the present arrangement, the structure 7 may be formed of silicon or a compound semiconductor material other than silicon, such as sapphire, GaN, SiC, or GaAs. In particular, the opening/closing piece 7a1, which opens and closes the structure 7a, may be made of plastic.

Since the above-described different types of semiconductor process carriers according to the first embodiment and the second and third arrangements are provided, it is possible to satisfy the requirements of processes, such as exposure, ion implantation, etching, deposition, and bonding, which are performed by semiconductor manufacturing apparatuses and in which the small substrate is transferred.
1) With an exposure apparatus, although the acceleration and rotation in the transferring process are small, high positioning accuracy is eventually required. Therefore, high positional accuracy needs to be achieved with regard to the position of the opening with respect to the mark that serves as a reference for the position of the semiconductor process carrier, and with regard to the method for fixing the small substrate in the opening. Accordingly, the semiconductor process carriers according to the first embodiment and also to the first arrangement, which each have an opening, are effective.
2) An ion implantation apparatus generally includes a mechanism capable of performing various types of rotation in an ion implantation process to achieve high in-plane uniformity. In addition, acceleration and centrifugal force are often applied during the process. Therefore, a structure in which the small substrate is not only placed in the opening but also fixed and covered with a structure is effective. Accordingly, the semiconductor process carriers according to the first second and third arrangements are effective.
3) In an etching apparatus, an electrostatic chuck is generally used to retain a silicon carrier. Therefore, the carrier itself is required to be retainable by an electrostatic chuck. In addition, the retained state needs to be maintained while machining and processing are performed. Therefore, the configuration in which the small substrate is retained by an electrostatic chuck through the polyimide film is effective. Accordingly, the semiconductor process carriers according to the first embodiment and also to the first arrangement are effective.
4) In a thin-film deposition apparatus, such as a CVD apparatus or a sputtering apparatus, adaptability to a transfer system and resistance to high temperatures in the deposition process are required, and the heat resistant characteristics of the polyimide film can be exploited. Accordingly, the semiconductor process carriers according to the first embodiment as well as the third arrangement are both effective.
5) In a high-temperature furnace for high-temperature annealing or the like, for SiC, high-temperature annealing is performed after ion implantation is performed to introduce impurities. For GaN, a high-temperature crystal growth process is performed. In addition, for silicon, a high-temperature furnace is used, for example, for impurity dispersion, formation of an oxidization film, or crystal growth. To withstand such a high-temperature process, materials, including those of the transferring system, and forming a structure which do not to cause adhesion or separation at high temperatures are required. Thus, the semiconductor process carriers according to the first embodiment as well as the third arrangement are effective.

In a semiconductor manufacturing process, a system for quality maintenance and early defect detection is established in which dimension measurements are performed at certain points in the manufacturing process by observation using an electron microscope or observational measurement using an optical microscope, and in which a measurement analysis device for X-ray fluorometry or the like is arranged. With these measurement devices, an electrostatic chuck for transferring the small substrate is required, and the small substrate needs to be accurately positioned. To satisfy these requirements, the semiconductor process carriers according to the first embodiment and the first arrangement are effective.

### EXAMPLES

A number of examples not forming part of the present invention but being useful to understand it will now be presented.

### EXAMPLE 1

### <Process 1>

To manufacture a transferring base portion, a hole was formed by an air spindle method. At this time, at least two supports were formed on inner surfaces so that the positional accuracy between the reference of the base substrate (notch or orientation flat) and the reference of the mounted wafer (orientation flat) was X, Y < ±200 µm, and Θ < 1 degrees. The two supports include a support on the orientation flat surface and a support orthogonal to the orientation flat surface (see Fig. 3).

### <Process 2>

A polyimide film was processed by laser machining.

### <Process 3>

To adjust an adhesive solution, a solvent-soluble polyimide solution was added for dilution, and mixing was performed by a planetary centrifugal mixer. Thus, the concentration of the polyimide adhesive solution was adjusted.

### <Process 4>

To apply the adhesive (to the entire surface) by spin coating, a piece of double-sided adhesive tape for use in a polishing process was bonded to a SEMI standard 6-inch silicon substrate, and a thermal release sheet was bonded to the double-sided adhesive tape. The transferring base portion for transfer manufactured by the above-described process was cleaned and bonded to the thermal release sheet. Solvent soluble polyimide for adhesion was applied to the transferring base portion by a spin coater. After that, a heating-and-drying process was performed by using a hot plate, and lastly a high-temperature drying process was performed. The solvent was volatilized by being heated.

### <Process 5>

A pressing process was performed by applying heat and pressure in the atmosphere.

### <Process 6>

The semiconductor process carrier of this example was evaluated by using a gas etching apparatus. As a result, an etching process for the small substrate was carried out without any problem.

### EXAMPLE 2

### <Process 1>

To manufacture a transferring base portion, a hole was formed by an air spindle method.

### <Process 2>

A polyimide film was processed by laser machining.

### <Process 3>

To adjust an adhesive solution, a solvent-soluble polyimide solution was added for dilution, and mixing was performed by a planetary centrifugal mixer. Thus, the concentration of the polyimide adhesive solution was adjusted.

### <Process 4>

The adhesive was applied (to a partial region) by screen printing.

### <Process 5>

A pressing process was performed by applying heat and pressure in vacuum or in the atmosphere. With regard to the bonding strength between the polyimide film and the base portion, the peal strength measured by peeling off the polyimide film in the direction of 180 degrees by a tension tester was greater than or equal to 250 gf/cm.

### <Process 6>

The semiconductor process carrier of this example was evaluated by using an exposure apparatus (NSR2205i12D produced by Nikon) which uses the i-line (365 nm) of a mercury lamp as a light source. More specifically, a small substrate was prepared by applying positive photoresist (GXR602 produced by AZ) to a 3-inch silicon substrate over the entire area thereof by spin coating. In the exposure apparatus, in the state in which the small substrate was fixed by an electrostatic chuck and attached to the exposure stage by a vacuum chuck, the small substrate was exposed to light with an amount of exposure of 80 mJ/cm², so that a pattern was formed thereon. Then, puddle development was performed by using tetramethylammonium hydroxide solution with a concentration of 2.38%. As a result, a desired resist pattern was formed. In addition, no erosion of the developer into the temporary fixing member occurred, and the bonding strength of the 3-inch silicon substrate was maintained.

The flatness of the surface of the small substrate after the attachment was measured. As a result, the flatness was within 5 µm, and it was confirmed that the flatness was realized to similar to that in an ordinary wafer transfer process. As a result of verification of the lithography process, it was confirmed that a pattern in which the line width and the space width were 1.0 µm and 1.2 µm, respectively, was appropriately formed. In addition, in the verification of L patterns, patterns of 0.6 µm, 0.5 µm, 0.4 µm, 0.3 µm, and 0.2 µm were formed, and it was confirmed that the patterns of up to 0.3 µm were appropriately formed. These results are similar to those obtained when the silicon carrier was not used and an ordinary SEMI standard 8-inch silicon substrate was used. Thus, it was confirmed the exposure process was effective.

### EXAMPLE 3: Manufacture of, in particular, heat-resistant silicon, see Figs. 5 and 6

### <Process 1>

To manufacture a structure including a substrate-receiving portion and a substrate-accommodating portion, a hole was formed by an air spindle method, and a silicon substrate was cut into a C-shape. At this time, at least two supports were formed on inner surfaces so that the positional accuracy between the reference of the base substrate (notch or orientation flat) and the reference of the mounted wafer (orientation flat) was X, Y < ±200 µm, and Θ < 1 degrees. The two supports included a support on the orientation flat surface and a support orthogonal to the orientation flat surface (see, for example, Fig. 3). In addition, a suction hole was formed in the transferring base substrate.

### <Process 2>

To bond the structure to the transferring base portion, the surfaces of the silicon substrate of the transferring base portion and the structure including the substrate-receiving portion and the substrate-accommodating portion were cleaned, so that particles or the like generated in the grinding process were cleaned. The cleaning process was performed so that no dust of 1 µm. or more remained on the surfaces.

### <Process 3>

An ionization process for silicon surfaces was performed so that the surfaces of the silicon substrate of the transferring base portion and the substrate-accommodating portion, in particular, of the structure were activated with ions.

### <Process 4>

The transferring base substrate and the substrate-accommodating portion were heated and pressed, and were bonded together by plasma bonding. At this time, the alignment accuracy can be increased by preparing a dedicated jig.

### <Process 5>

Another ionization process for silicon surfaces was performed so that the surfaces of the substrate-accommodating portion and the substrate-receiving portion, in particular, of the structure were activated with ions.

### <Process 6>

The substrate-accommodating portion and the substrate-receiving portion were heated and pressed, and were bonded together by plasma bonding. At this time, the alignment accuracy can be increased by preparing a dedicated jig.

Since the heat resistant carrier and the like are formed of conductors (silicon, compound wafer), the small substrate cannot be attracted to the semiconductor apparatus (electrostatic chuck). More specifically, when the conductors are present, the electric field does not reach the small substrate, and therefore an attraction force cannot be applied to the small substrate. Although a thin film material of 50 µm or less having a heat resistance temperature higher than or equal to that of polyimide may be bonded between the semiconductor apparatus (electrostatic chuck) and the small substrate in place of the conductors (silicon, compound wafer), glass and the like has a risk of cracking, and therefore cannot be used.

Accordingly, as illustrated in Fig. 9, an example useful for understanding the present invention includes a semiconductor process carrier in which a charge-storage layer 103, which includes a dielectric material 106, and wiring layers 104 and 105, are stacked on a silicon substrate that serves as a transferring base portion 101, and a structure 108 is bonded to such a stack. More specifically, the charge-storage layer 103 is stacked on the silicon substrate, which serves as the transferring base portion 101, with an insulating layer 102 made of SiO₂ or the like interposed therebetween, and the wiring layers 104 and 105, which include V+ and V- external terminals, are formed in the charge-storage layer 103. The structure 108, which includes a substrate-receiving portion and a substrate-accommodating portion, is bonded to the charge-storage layer 103. Thus, when a voltage is applied to the wiring layers 104 and 105 including the V+ and V- external terminals, a small substrate 107 is attracted to the wiring layers 104 and 105 through a thin dielectric 106. Even after the external voltage has been turned off, the attraction force is maintained by the charge stored in the charge-storage layer 103. Since the silicon carrier can be attached to an electrostatic chuck stage in the semiconductor manufacturing apparatus, the small substrate can be attached to the semiconductor manufacturing apparatus.

### Industrial Applicability

Thanks to the present invention, a process for a compound semiconductor substrate including a small-diameter semiconductor substrate may be performed by a semiconductor manufacturing apparatus for large-diameter silicon substrates. In such a case, it is not necessary to modify the line. In addition, the substrate size can be changed by replacing the semiconductor process carrier In the case where the line is modified, generally, the cost is several tens of millions of yen to a hundred million yen or more, and the modification of the apparatus takes about three months or more from ordering to delivery and operation check. Therefore, by using the strucutre according to the present invention, the manufacturing period can be reduced and a significant cost reduction can be achieved.

The present invention may be applied not only to processes for semiconductor components but also to those for mounting components and mechanical components, as long as workpieces are not influenced.

Although an embodiment of the present invention have been described, the above-described embodiment is a mere example of the present invention, and various design changes are possible in accordance with the present invention as long as they do not depart from the scope of the claims. For example, the transferring base portion formed of a semiconductor substrate according to the present invention may include a compound semiconductor substrate, instead of a large-diameter silicon substrate, as a base material.

### Reference sign list

- 1: transferring base portion
- 10: opening
- 11: first support
- 12: second support
- 13: third support
- 14: reference point
- 1a: transferring base portion
- 2: polyimide film
- 3: adhesive portion
- 4: sapphire substrate (small substrate)
- 5: hole
- 6: electrostatic chuck stage
- 7: structure
- 7b: substrate-receiving portion
- 7c: substrate-accommodating portion
- 71: cover portion
- 72: spacer portion
- 7a: structure
- 7a1: opening/closing piece
- 8: metal spring
- 101: transferring base portion
- 102: insulating layer
- 103: charge-storage layer
- 104: wiring layer (V+)
- 105: wiring layer (V-)
- 106: dielectric material
- 107: small substrate
- 108: structure

## Claims

1. A combination of a small substrate, a semiconductor process carrier for use on an electrostatic chuck and an electrostatic chuck stage (6), wherein the semiconductor process carrier includes a transferring base portion (1) formed of a semiconductor substrate for enabling a small substrate to be held,
wherein an opening (10) is formed in the transferring base portion (1), and a polyimide film (2) is attached to a bottom surface of the transferring base portion (1) so as to cover the opening (10),
wherein the small substrate is accommodated in the opening, the small substrate having a diameter smaller than a diameter of the transferring base portion (1) or a shape different from a shape of the transferring base portion (1),
wherein a hole (5) for securing the small substrate by vacuum chuck or cooling the small substrate is formed in the polyimide film (2) covering the opening and
wherein the transferring base portion (1) and the small substrate are attached by an electrostatic force to an electrostatic chuck stage (6), and
wherein the polyimide film (2) is disposed between the transferring base portion (1) and the electrostatic chuck stage (6).

2. The semiconductor process carrier according to Claim 1, wherein the polyimide film (2) has a thickness of 50 µm or less.

## Patentansprüche

1. Kombination eines kleinen Substrats, eines Halbleiterprozessträgers zur Verwendung auf einer elektrostatischen Spannvorrichtung und einer elektrostatischen Spannvorrichtungsstufe (6), wobei der Halbleiterprozessträger einen aus einem Halbleitersubstrat ausgebildeten Übertragungsbasisabschnitt (1) beinhaltet um zu ermöglichen, dass ein kleines Substrat festgehalten wird, ,
wobei eine Öffnung (10) in dem Übertragungsbasisabschnitt (1) ausgebildet ist, und eine Polyimidfolie (2) an einer unteren Oberfläche des Übertragungsbasisabschnitts (1) angebracht ist, um die Öffnung (10) abzudecken,
wobei das kleine Substrat in der Öffnung untergebracht ist, wobei das kleine Substrat einen Durchmesser kleiner als ein Durchmesser des Übertragungsbasisabschnitts (1) aufweist oder eine Form aufweist, die sich von einer Form des Übertragungsbasisabschnitts (1) unterscheidet, wobei ein Loch (5) zum Sichern des kleinen Substrats durch eine Vakuumspannvorrichtung oder Kühlen des kleinen Substrats in der die Öffnung bedeckenden Polyimidfolie (2) ausgebildet ist und
wobei der Übertragungsbasisabschnitt (1) und das kleine Substrat durch eine elektrostatische Kraft an einer elektrostatischen Spannvorrichtungsstufe (6) angebracht sind, und
wobei die Polyimidfolie (2) zwischen dem Übertragungsbasisabschnitt (1) und der elektrostatischen Spannvorrichtungsstufe (6) angeordnet ist.

2. Halbleiterprozessträger nach Anspruch 1, wobei die Polyimidfolie (2) eine Dicke von höchstens 50 µm aufweist.

## Revendications

1. Combinaison d'un petit substrat, d'un support de traitement de semi-conducteur destiné à être utilisé sur un mandrin électrostatique et d'une platine de mandrin électrostatique (6), le support de traitement de semi-conducteur comportant une partie de base de transfert (1) formée d'un substrat semi-conducteur pour permettre la retenue d'un petit substrat,
dans lequel une ouverture (10) est formée dans la partie de base de transfert (1), et un film de polyimide (2) est fixé à une surface inférieure de la partie de base de transfert (1) de manière à couvrir l'ouverture (10),
dans laquelle le petit substrat est logé dans l'ouverture, le petit substrat ayant un diamètre inférieur à un diamètre de la partie de base de transfert (1) ou une forme différente d'une forme de la partie de base de transfert (1),
dans laquelle un trou (5) pour fixer le petit substrat par un plateau de maintien à vide ou refroidir le petit substrat est formé dans le film de polyimide (2) couvrant l'ouverture et
dans laquelle la partie de base de transfert (1) et le petit substrat sont fixés par une force électrostatique à une platine de mandrin électrostatique (6), et
dans laquelle le film de polyimide (2) est disposé entre la partie de base de transfert (1) et la platine de mandrin électrostatique (6).

2. Support de traitement de semi-conducteur selon la revendication 1, dans lequel le film de polyimide (2) a une épaisseur de 50 µm ou moins.
